# FASCICULE DE BREVET EUROPEEN

(11) **EP 2 359 197 B1**
(45) Date de publication et mention de la délivrance du brevet: **07.01.2015**
(21) Numéro de dépôt: 09751882.3
(22) Date de dépôt: 04.11.2009
(51) Int. Cl.: B81C 3/00, G04B 13/02, G04B 15/14, G04D 3/00

(54) **PROCÉDÉ DE FABRICATION D'UNE PIÈCE DE MICROMÉCANIQUE**
VERFAHREN ZUR HERSTELLUNG EINES MIKROMECHANISCHEN BAUTEILS
METHOD FOR MANUFACTURING A MICROMECHANICAL PART

(30) Priorité: 21.11.2008 EP 08169687
(43) Date de publication de la demande: 24.08.2011
(73) Titulaire: Nivarox-FAR S.A., 2400 Le Locle (CH)
(72) Inventeur: FUSSINGER, Alexandre, CH-2075 Wavre (CH); VERARDO, Marco, CH-2336 Les Bois (CH)
(74) Mandataire: Couillard, Yann Luc Raymond
(86) Numéro de dépôt international: PCT/EP2009/064639
(87) Numéro de publication internationale: WO 2010/057777

(56) Documents cités:
- EP-A- 0 994 398
- EP-A- 1 035 453
- EP-A- 1 921 042
- WO-A-2005/079128
- CH-A- 276 772

## Description

### Domaine de l'invention

L'invention se rapporte à un procédé de fabrication d'une pièce de micromécanique et plus particulièrement à un tel procédé destiné à assembler des parties micro-usinées et/ou électroformées.

### Arrière plan de l'invention

L'horlogerie trouve un avantage à fabriquer des pièces ou une partie des pièces à l'aide de processus de micro-usinage, par exemple une photolithographie puis un gravage ionique réactif profond ou d'électrodéposition, par exemple une photolithographie puis une croissance galvanique. En effet, de tels processus autorisent une fabrication avec une précision améliorée par rapport aux techniques habituelles.

Cependant, il est difficile de former des pièces à partir de plusieurs parties. Ainsi, dans le cas de pièces électroformées, une soudure laser entre deux parties et, par exemple, un axe, risque de déformer ces derniers en perdant la très bonne précision induite par le processus d'électrodéposition. De plus, quel que soit le processus, la précision d'assemblage entre deux pièces et, par exemple, un axe de pivotement est très difficile à obtenir.

Un procédé de fabrication d'une pièce de micromécanique est divulguée dans le document WO 2005079128.

### Résumé de l'invention

Le but de la présente invention est de pallier tout ou partie les inconvénients cités précédemment en proposant un procédé de fabrication d'une pièce de micromécanique comportant, par exemple, au moins trois parties dont la précision d'assemblage n'altère pas la précision desdits processus.

A cet effet, l'invention se rapporte à un procédé de fabrication d'une pièce de micromécanique à plusieurs niveaux comportant les étapes suivantes :
a) former au moins deux plaques comportant chacune un cadre relié par au moins un pont de matière à une partie de ladite pièce ;
b) empiler contre un support lesdites au moins deux plaques afin d'empiler au moins deux desdites parties ;
   caractérisé en ce qu'il comporte en outre les étapes suivantes :
c) solidariser une même cheville dans un trou de chacune desdites au moins deux parties empilées afin de former la pièce avec une cheville unique en saillie d'au moins une des plaques empilées afin de pouvoir s'en servir comme moyen de préhension ;
d) libérer la pièce formée desdites au moins deux plaques.

Avantageusement selon l'invention, il est possible de fabriquer une partie à partir de n'importe quel processus (micro-usinage, électroformage, électroérosion, étampage) sans avoir à manipuler ladite partie avant son montage final mais uniquement au moyen dudit cadre et de ladite cheville. De plus, on utilise le repère du support pour fabriquer plus précisément la pièce finale tout en gardant la précision du processus (micro-usinage, électroformage, électroérosion, étampage) utilisé pour réaliser chaque partie lors de l'étape a).

Conformément à d'autres caractéristiques avantageuses de l'invention :
- l'étape b) comporte, pour chaque plaque, les étapes e) : guider ladite plaque à l'aide de moyens d'alignement afin d'orienter fiablement ladite plaque par rapport au support et f) : glisser ladite plaque contre au moins un axe solidaire du support jusqu'à buter contre un épaulement dudit axe afin de placer fiablement ladite plaque par rapport au support ;
- chacun desdits moyens d'alignement comportent au moins un anneau biseauté monté en prolongement dudit au moins un axe du support et destiné à coopérer avec un évidement réalisé dans chacune desdites au moins deux plaques lors de l'étape a) ;

- le guidage de l'étape e) est réalisée avec au moins deux moyens d'alignement afin d'en améliorer la fiabilité ;
- chaque évidement est réalisé dans le cadre desdites au moins deux plaques ou correspond à un espace entre le cadre et la partie de chacune desdites au moins deux plaques ;
- chaque au moins un pont de matière comporte une section rétrécie à l'extrémité reliée à ladite partie de la pièce permettant de créer une zone de faiblesse apte à faciliter l'étape d) ;
- plusieurs parties sont formées sur chaque plaque afin de former plusieurs pièces lors de l'étape c) ;
- la cheville est prolongée à chacune de ses extrémités par un tigeron comportant un pivot afin de former un axe de pivotement ;
- la cheville comporte coaxialement un anneau destiné à servir de butée pour limiter la pénétration de ladite cheville dans lesdits trous ;
- ledit anneau coaxial comporte une denture afin de former un pignon ;
- au moins une desdites plaques est formée lors de l'étape a) à l'aide d'un processus d'électrodéposition et/ou de micro-usinage.
- au moins une sous-partie peut être montée sur au moins une desdites parties de manière latérale par rapport à ladite plaque avant, pendant ou après l'étape b).

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation schématique de deux plaques selon l'invention ;
- les figures 2 à 4 sont des représentations schématiques d'étapes successives selon le procédé de l'invention ;
- les figures 5 à 7 sont des représentations schématiques de pièces de micromécanique réalisables selon le procédé de l'invention ;
- la figure 8 est un schéma fonctionnel du procédé selon l'invention.

### Description détaillée des modes de réalisation préférés

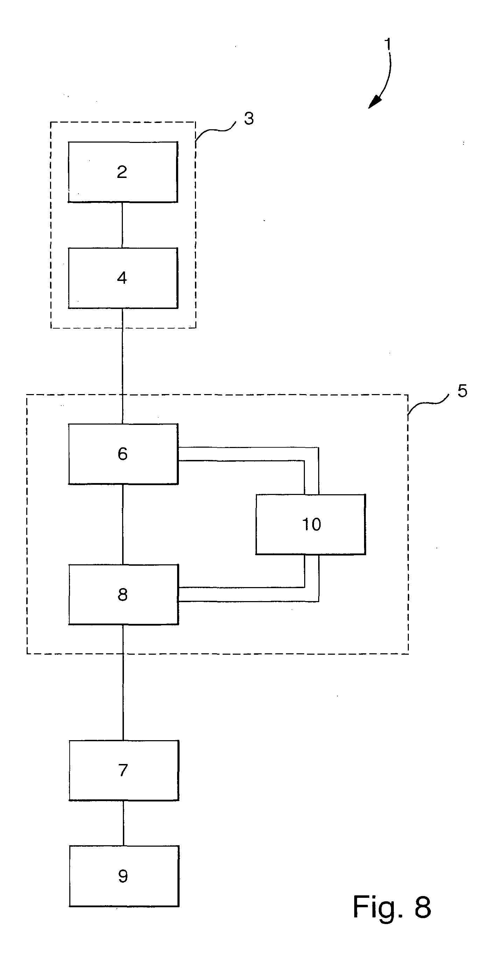

Comme illustré à la figure 8, l'invention se rapporte à un procédé 1 de fabrication d'une pièce 31, 41, 51 de micromécanique. Le procédé 1 est destiné à assembler fixement au moins deux parties 19, 21 distinctes par empilement à l'aide d'une cheville 29. Le procédé 1 comporte une étape 3 de réalisation des parties 19, 21 de la pièce finale 31, 41, 51, une étape 5 d'empilement des plaques 11, 13 comportant lesdites parties, une étape 7 de solidarisation desdites parties puis une étape 9 de libération des plaques 11, 13 de la pièce 31, 41, 51 ainsi formée.

Avantageusement selon l'invention, la première étape 3 de réalisation des parties 19, 21 de la pièce 31, 41, 51 peut être effectuée à l'aide de processus de micro-usinage et/ou d'électrodéposition. Un processus de micro-usinage, c'est-à-dire une précision d'usinage sensiblement égale ou inférieure au micron, peut comporter, par exemple, une photolithographie destinée à former un masque de protection sur une plaque de matériau micro-usinable puis une attaque des parties non protégée de ladite plaque, par exemple, par un gravage ionique réactif profond. Un matériau micro-usinable peut ainsi consister, par exemple, en un matériau à base de silicium, de silice cristallisée ou d'alumine cristallisée. Bien entendu, d'autres matériaux peuvent être prévus.

Un processus d'électrodéposition peut comporter, par exemple, une photolithographie destinée à former un moule dans lequel une croissance galvanique est effectuée. Un matériau de croissance galvanique peut ainsi consister, par exemple, en un matériau métallique comme du nickel pur ou du nickel-phosphore. Bien entendu, d'autres matériaux peuvent être prévus.

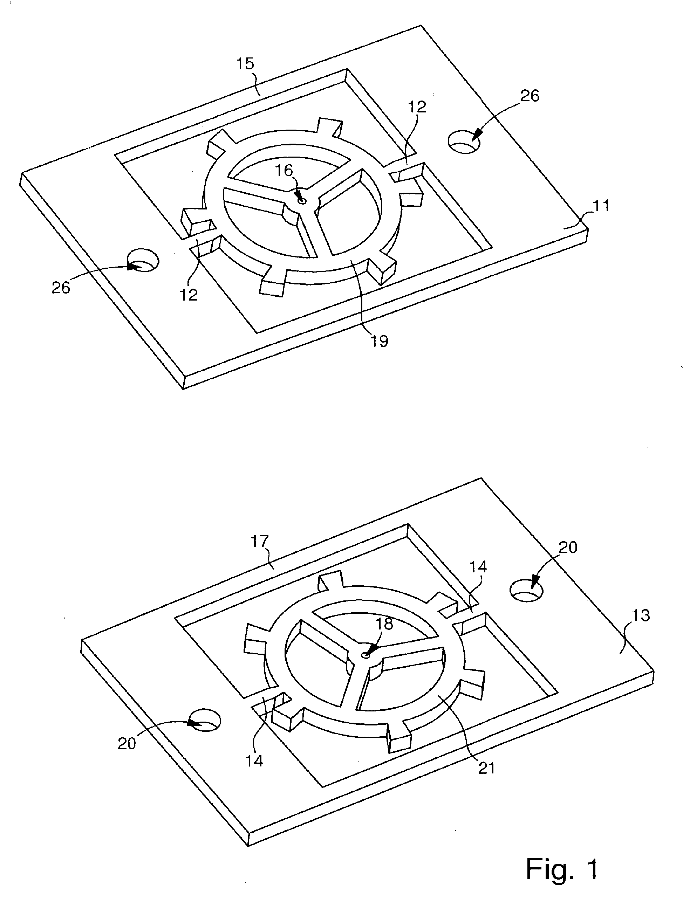

L'étape 3 de réalisation comporte au moins deux phases distinctes 2, 4 de formation. Chaque phase 2, 4 à l'aide desdits processus de micro-usinage et/ou d'électrodéposition est destinée à former respectivement une plaque 11, 13 comme illustrées à la figure 1. Chaque plaque 11, 13 comporte un cadre 15, 17 relié par au moins un pont de matière 12, 14 à une partie 19, 21 destinée à la fabrication de la pièce 31, 41, 51 finale. Comme visible à la figure 1, chaque partie 19, 21 comporte préférentiellement un trou traversant 16, 18.

On comprend donc que la pièce finale 31, 41, 51 peut être réalisée, soit à partir d'un même processus, soit à partir de plusieurs processus différents. Bien entendu, d'autres processus que le micro-usinage et/ou l'électrodéposition qui permettent de fabriquer de telles plaques 11, 13, etc. peuvent être prévus tels que l'électroérosion ou l'étampage.

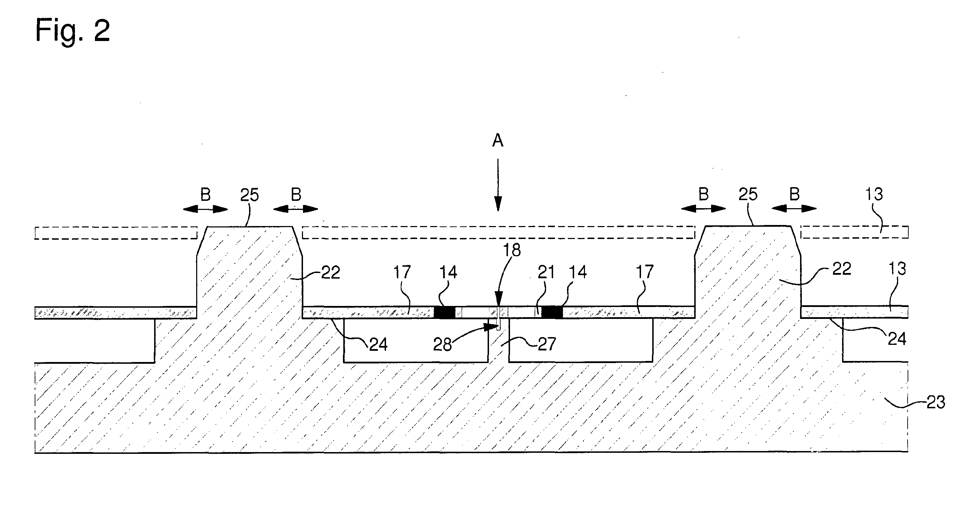

Selon l'invention, le procédé 1 comporte une deuxième étape 5 destinée à empiler les plaques 11, 13 contre un support 23. Dans l'exemple illustré aux figures 2 à 4, le support 23 comporte au moins un axe 22 destiné à coopérer avec un évidement associé 20, 26 qui est réalisé dans la plaque 13, 11 à empiler. Un tel ensemble axe 22 - évidement 20, 26 permet de précisément placer la plaque 13, 11 par rapport au support 23.

Préférentiellement selon l'invention, chaque axe 22 comporte un épaulement 24 destiné à fiabiliser l'éloignement de la plaque 13, 11 par rapport au support 23. De manière préférée, le support 23 comporte également des moyens d'alignement 25 permettant d'orienter fiablement la plaque 13, 11 par rapport au support 23. Dans l'exemple illustré aux figures 2 à 4, les moyens d'alignement 25 comporte un anneau biseauté monté en prolongement de chaque axe 22 et destiné à coopérer avec un des évidements 20, 26 réalisés dans la plaque 13, 11.

Selon une première phase 6 de la deuxième étape 5 illustrée à la figure 2, une première plaque 13 est montée contre le support 23. Dans un premier temps, la plaque 13 est approchée du support 23 selon la direction A. Dans un deuxième temps, la plaque 13, illustrée par des traits discontinus, rencontre les moyens d'alignement 25 afin d'être guidée selon la direction B. Grâce aux moyens d'alignement 25 et aux évidements 20, la plaque 13 est orientée fiablement afin que les évidements 20 se placent à l'aplomb de chaque axe 22 du support 23. Dans un troisième temps, la plaque 13 est glissée selon la direction A au moyen de ses évidements 20 contre leur axe 22 jusqu'à ce qu'elle entre en contact, dans un quatrième temps, avec les épaulements 24 de chaque axe 22 comme illustré à la figure 2. On comprend donc que la plaque 13 est placée très précisément par rapport au support 23.

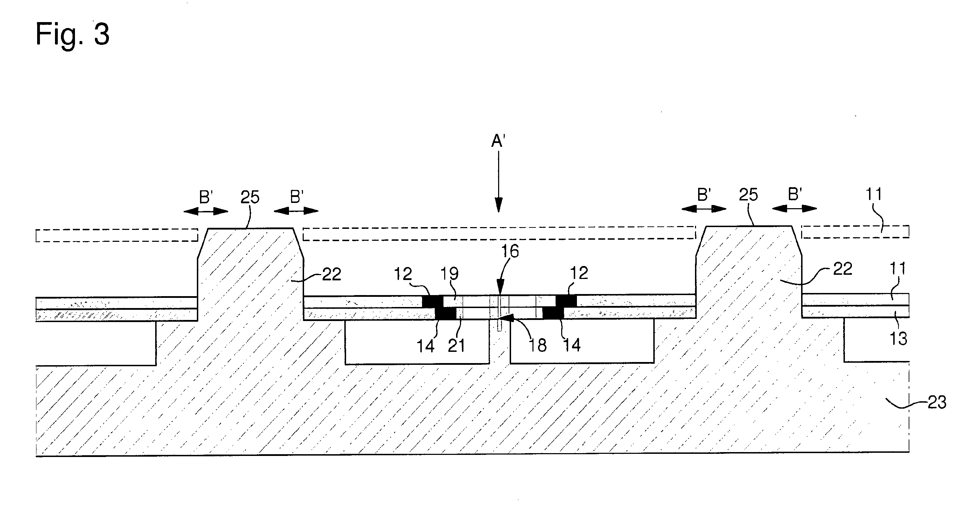

Selon une deuxième phase 8 de la deuxième étape 5 illustrée à la figure 3, une deuxième plaque 11 est montée contre le support 23 en empilement par rapport à la première 13. Dans un premier temps, la plaque 11 est approchée du support 23 selon la direction A'. Dans un deuxième temps, la plaque 11, illustrée par des traits discontinus, rencontre les moyens d'alignement 25 afin d'être guidée selon la direction B'. Grâce aux moyens d'alignement 25 et aux évidements 26, la plaque 11 est orientée fiablement afin que les évidements 26 se placent à l'aplomb de chaque axe 22 du support 23. Dans un troisième temps, la plaque 13 est glissée selon la direction A' au moyen de ses évidements 26 contre leur axe 22 jusqu'à ce qu'elle entre en contact, dans un quatrième temps, avec le dessus de la première plaque 13 comme illustré à la figure 3.

On comprend donc que les plaques 11 et 13 sont placées très précisément par rapport au support 23 et, incidemment, l'une par rapport à l'autre. On remarque également que la partie 21 de la plaque 13 est située en dessous et en contact avec la partie 19 de la plaque 11. Enfin, on peut également voir que, dans l'exemple illustré à la figure 3, les trous 16 et 18 sont sensiblement alignés à l'aplomb l'un de l'autre.

Bien entendu, les première 3 et deuxième 5 étapes ne sauraient se limiter à la réalisation puis l'empilement de deux uniques plaques 11 et 13. En effet, le procédé 1 autorise avantageusement que plus ou moins de deux plaques soient réalisées lors de l'étape 3 afin de fabriquer une pièce 31, 41, 51 à partir de plus ou moins de deux parties empilées sur le support 23 lors de l'étape 5. On comprend également que plus ou moins de phases 2, 4 soient nécessaires à l'étape 3 et plus ou moins de phases 6, 8 à l'étape 5.

Selon l'invention, le procédé 1 comporte une troisième étape 7 destinée à solidariser chacune des parties 19, 21 empilées afin de former la pièce 31, 41, 51 de micromécanique. Préférentiellement selon l'invention, l'étape 7 de solidarisation est effectuée à l'aide du montage d'une cheville 29 dans les trous 16, 18 de chaque partie 19, 21. A cet effet, préférentiellement, le support 23 comporte également un pilier 27 comprenant une partie supérieure creuse 28 permettant, lors de l'introduction de la cheville 29 dans leur trou respectif 16, 18, d'éviter tout déplacement relatif entre les parties 19, 21 et leur plaque 11, 13. En effet, un tel déplacement relatif entraînerait un risque de rupture des ponts de matière 12, 14 non souhaitée à cette troisième étape 7 du procédé 1.

Selon la nature des matériaux utilisés pour réaliser les plaques 11, 13, etc., il peut être envisagé plusieurs modes de réalisation de la troisième étape 7. Ainsi, selon l'invention, les modes de réalisation préférés sont le chassage, le soudage et le collage. Bien entendu, si une des plaques 11, 13, etc. est en matériau ne comportant pas ou peu de domaine de déformation plastique, il devient difficile de réaliser un chassage.

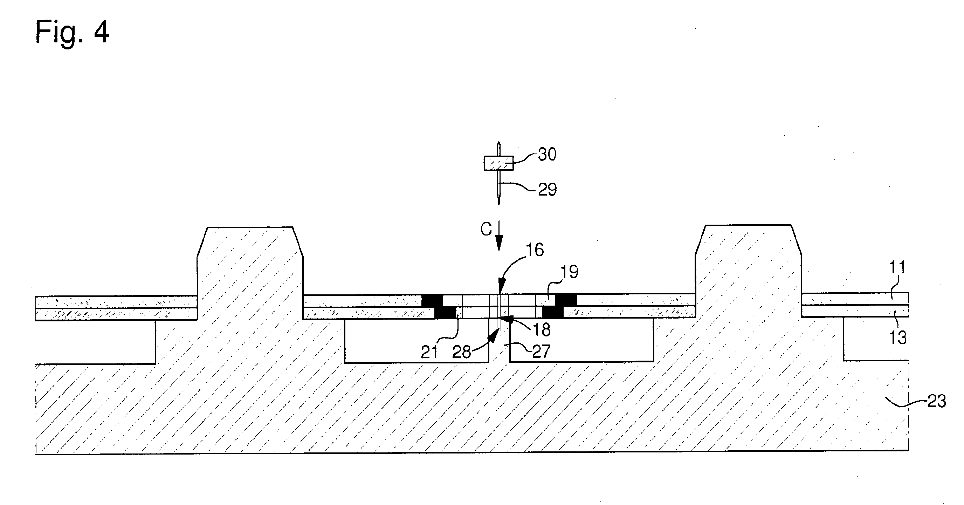

Dans un premier mode de réalisation relatif au chassage, dans l'exemple illustré à la figure 4, dans un premier temps de la troisième étape 7, la cheville 29 est rapprochée selon la direction C de chacun des trous 16, 18 empilés. Dans un deuxième temps, la cheville 29 est enfoncée en force dans les trous 16 puis 18 des plaques 11 et 13. Avantageusement, la force de chassage peut être régulée par utilisation d'un automate. Chaque partie 19 et 21 devient alors solidaire de la cheville 29 et forme la pièce finale 31, 41,51.

Dans un deuxième mode de réalisation relatif au soudage, dans l'exemple illustré à la figure 4, dans un premier temps de la troisième étape 7, la cheville 29 est enduite d'une brasure. Dans un deuxième temps, la cheville 29 est rapprochée selon la direction C de chacun des trous 16, 18 empilés. Dans un troisième temps, la cheville 29 est introduite dans les trous 16 puis 18 des plaques 11 et 13. Avantageusement, la précision de la direction C peut être améliorée par utilisation d'un automate. Dans un quatrième temps, la brasure est solidifiée, par exemple, à l'aide d'un traitement thermique. Chaque partie 19 et 21 devient alors solidaire de la cheville 29 et forme la pièce finale 31, 41, 51.

Dans un troisième mode de réalisation relatif au collage, dans l'exemple illustré à la figure 4, dans un premier temps de la troisième étape 7, la cheville 29 est enduite d'un matériau adhésif, par exemple, du type colle polymère. Dans un deuxième temps, la cheville 29 est rapprochée selon la direction C de chacun des trous 16, 18 empilés. Dans un troisième temps, la cheville 29 est introduite dans les trous 16 puis 18 des plaques 11 et 13. Avantageusement, la précision de la direction C peut être améliorée par utilisation d'un automate. Dans un quatrième temps, le matériau adhésif est activé, par exemple, par chauffage. Chaque partie 19 et 21 devient alors solidaire de la cheville 29 et forme la pièce finale 31, 41, 51.

Selon l'invention, le procédé 1 comporte une quatrième étape 9 destinée à libérer la pièce 31, 41, 51 de micromécanique formée de chacune des plaques 19, 21, etc. empilées lors de la deuxième étape 5. L'étape 9 est préférentiellement réalisé en exerçant une force apte à rompre les ponts de matière 12, 14.

De manière préférée pour tous les modes de réalisation de la troisième étape 7, la cheville 29 est montée solidaire en saillie d'au moins une des plaques empilées afin de pouvoir s'en servir comme moyen de préhension, c'est-à-dire sans avoir à manipuler les parties 19, 21, etc. de chaque plaque 11, 13, etc. Avantageusement, le procédé 1 autorise ainsi une grande qualité de surface de chacune des parties. On comprend également que la partie supérieure creuse 28 du pilier 27 monté sur le support 23 permet à la cheville 29 de dépasser du dessous de la plaque 13 et/ou de borner son enfoncement dans les trous 16, 18, etc.

Selon une première variante de l'invention, la cheville 29 comporte un anneau 30 formant butée au niveau de ladite saillie afin de limiter la pénétration de la cheville 29 dans les trous des parties. L'anneau 30 permet ainsi une amélioration de qualité de fabrication. De plus, l'anneau 30 qui peut être venu de matière avec la cheville 29 peut également, de manière avantageuse, comporter une denture apte à former un pignon comme expliqué ci-dessous.

Selon une deuxième variante de l'invention, en plus de l'anneau 30, la cheville 29 peut également être prolongée à chacune de ses extrémités par un tigeron comportant un pivot afin de former un axe de pivotement. Avantageusement selon l'invention, on comprend donc qu'il est possible, dans la troisième étape 7, de solidariser dans les trous des parties empilées une multiplicité d'élément qui peut varier d'une simple cheville 29 jusqu'à un axe de pivotement muni d'au moins un pignon.

A la lecture du procédé 1, on comprend qu'il est possible de former plusieurs parties 19, 21, etc. identiques ou non sur chaque plaque 11, 13, etc. afin de fabriquer en série des pièces finales 31, 41, 51 identiques ou non. On comprend également que les plaques 11, 13, etc. après la troisième étape 7 peuvent être livrées directement aux lignes de production, par exemple, de mouvements pour pièces d'horlogerie avant qu'il y soit réalisé la quatrième étape 9. Cela a pour avantage de manipuler uniquement les cadres 15, 17, etc. des plaques 11, 13, etc. de beaucoup de pièces finales en même temps sans risque de détérioration par manipulation desdites parties 19, 21, etc. empilées.

Avantageusement, le procédé 1 permet donc une précision de fabrication améliorée, la possibilité de fabriquer de manière flexible des pièces composites, c'est-à-dire comportant plusieurs matériaux différents, de grande qualité sans avoir à manipuler les parties de la pièce finale avec une grande simplicité et une multiplicité du nombre de plaques. On comprend donc que le procédé 1 peut être entièrement automatisé, par exemple, à l'aide d'une chaîne de production multipostes.

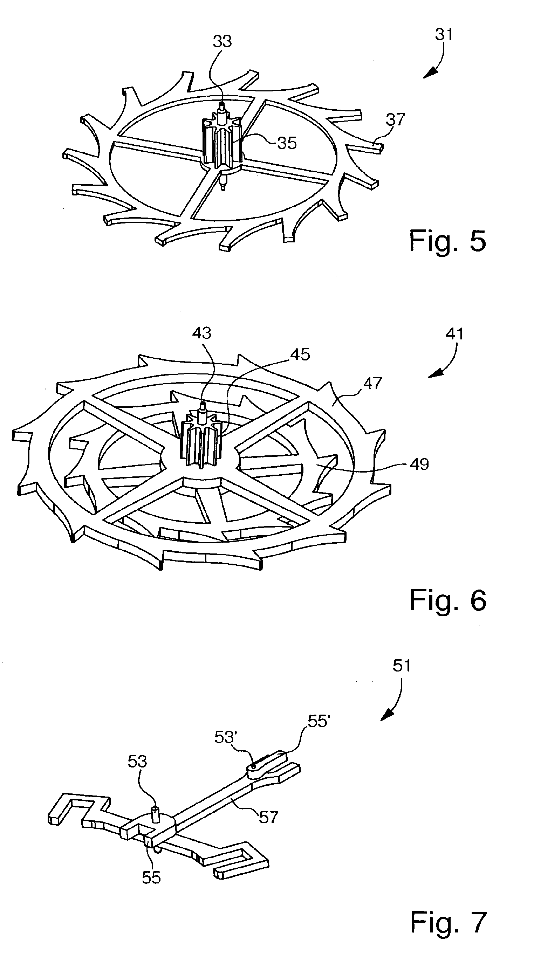

En référence aux figures 5 à 7, des exemples de fabrication de pièces de micromécanique Selon le procédé 1 sont présentées. Dans l'exemple illustré à la figure 5, on peut voir un mobile 31 de pièce d'horlogerie qui comporte un axe de pivotement 33, un pignon 35 et une roue dentée 37. Le procédé 1 peut autoriser, par exemple, que le pignon 35 soit une partie d'une plaque obtenue par un processus d'électrodéposition et la roue 37 à partir d'une plaque obtenue par un processus de micro-usinage.

Dans l'exemple illustré à la figure 6, on peut voir un mobile 41 de pièce d'horlogerie qui comporte un axe de pivotement 43, un pignon 45 et deux roues dentées 47, 49. Le procédé 1 peut autoriser, par exemple, que le pignon 45 soit une partie d'une plaque obtenue par un processus d'électrodéposition et les roues 47, 49 à partir de plaques obtenues par un processus de micro-usinage.

Avantageusement, selon la première variante expliquée ci-dessus, les pignons 35, 45 peuvent également venir de matière avec respectivement les axes 33, 43 et ainsi former des ensembles aptes à solidariser les pièces finales 31, 41 lors de la troisième étape 7 du procédé 1.

On comprend donc qu'il peut être envisagé une multitude de pièces de micromécanique à fabriquer suivant les matériaux utilisés, les modes de réalisation utilisés et/ou les variantes choisies. Ainsi, à titre d'exemple, comme illustré à la figure 7, il peut également être envisagé de fabriquer une ancre 51 de pièce d'horlogerie qui comporte un axe de pivotement 53, un bras supérieur 55, un corps principal 57 mais également un dard 55' et éventuellement une cheville 53'.

Le procédé 1 peut autoriser, par exemple, que l'ancre 51 soit obtenue à l'aide de parties uniquement à base de silicium. Une telle ancre 51 pourrait être obtenue à partir de deux plaques réalisées par un processus de micro-usinage lors de l'étape 3, empilées lors de l'étape 5 sur un support 23, le bras supérieur 55 et le dard 55' étant solidarisée au corps principal 57 au moyen respectivement d'un axe 53 et d'une cheville 53' par collage lors de l'étape 7, l'ancre 51 étant libérée desdites plaques en exerçant une force sur l'axe 53 lors de l'étape finale 9.

Bien entendu, la présente invention ne se limite pas à l'exemple illustré mais est susceptible de diverses variantes et modifications qui apparaîtront à l'homme de l'art. En particulier, il peut être envisagé lors de l'étape 5, comme illustré à la figure 8 en trait double, une phase intermédiaire 10 de dépôt d'un matériau adhésif entre chaque plaque 11, 13, etc. empilée et/ou l'anneau 30. Un tel matériau adhésif permet l'amélioration locale de la solidarisation entre au moins deux éléments de la pièce finale si nécessaire. Le matériau adhésif peut être déposé par un processus de sérigraphie autorisant son dépôt selon une épaisseur et une surface précises.

De plus, afin de prévoir l'endroit de rupture lors de l'étape 9, comme illustré à la figure 1, il peut être prévu que chaque un pont de matière 12, 14 comporte une section rétrécie à l'extrémité reliée sa partie associée 19, 21.

Il peut également y avoir plus ou moins d'ensembles axe 22 - évidement 20, 26. De plus, ces évidements 20, 26 peuvent être remplacés par des évidements déjà existants entre le cadre 15, 17 et les partie 19, 21 des plaques 11, 13.

Enfin, tous les composants selon l'explication ci-dessus sont montés à chaque étape sensiblement de manière verticale uniquement pour faciliter la compréhension de l'invention. En effet, la direction de montage de composant ne saurait se limiter aux directions A, A' ou C. En effet, par exemple, dans le cas de la fabrication de l'ancre 51, il peut être envisagé de monter les palettes avant, pendant ou après l'étape 5 par un côté ajouré du cadre 15, 17, etc. de la plaque 11, 13, etc. utilisée pour former la partie 57 et/ou le bras supérieur 55. En effet, le positionnement des palettes ayant une très grande importance, le montage contre le support 23 lors des phases 6, 8, etc. de l'étape 5 peut être utilisé pour monter les palettes très précisément selon une direction sensiblement perpendiculaire à la direction A, A', C. Plus généralement, on comprend qu'au moins une sous-partie peut être montée sur au moins une desdites parties de manière latérale par rapport à ladite plaque avant, pendant ou après l'étape 5.

## Revendications

1. Procédé de fabrication (1) d'une pièce de micromécanique (31, 41, 51) comportant les étapes suivantes :
a) former (3) au moins deux plaques (11, 13) comportant chacune un cadre (15, 17) relié par au moins un pont de matière (12, 14) à une partie (19, 21) de ladite pièce ;
b) empiler (5) contre un support (23) lesdites au moins deux plaques afin d'empiler au moins deux desdites parties ;
**caractérisé en ce qu'**il comporte en outre les étapes suivantes :
c) solidariser (7) une même cheville (29) dans un trou (16, 18) de chaque au moins deux parties empilées afin de former la pièce (31, 41, 51) avec une cheville unique en saillie d'au moins une des plaques empilées afin de pouvoir s'en servir comme moyen de préhension ;
d) libérer (9) la pièce formée (31, 41, 51) desdites au moins deux plaques (11, 13).

2. Procédé (1) selon la revendication 1, **caractérisé en ce que** l'étape b) comporte pour chaque plaque (11, 13) les étapes suivantes :
e) guider (B) ladite plaque à l'aide de moyens d'alignement (25) afin d'orienter fiablement ladite plaque par rapport au support (23) ;
f) glisser (A) ladite plaque contre au moins un axe (22) solidaire du support (23) jusqu'à buter contre un épaulement (24) dudit axe afin de placer fiablement ladite plaque par rapport au support (23).

3. Procédé (1) selon la revendication 2, **caractérisé en ce que** chacun desdits moyens d'alignement comportent au moins un anneau biseauté monté en prolongement dudit au moins un axe du support (23) et destiné à coopérer avec un évidement (20, 26) réalisé dans chacune desdites au moins deux plaques lors de l'étape a).

4. Procédé (1) selon la revendication 2 ou 3, **caractérisé en ce que** le guidage de l'étape e) est réalisée avec au moins deux moyens d'alignement (25) afin d'en améliorer la fiabilité.

5. Procédé (1) selon la revendication 3 ou 4 quand elle dépend de la 3, **caractérisé en ce que** chaque évidement (20, 26) est réalisé dans le cadre (15, 17) desdites au moins deux plaques.

6. Procédé (1) selon la revendication 3 ou 4 quand elle dépend de la 3, **caractérisé en ce que** chaque évidement correspond à un espace entre le cadre (15, 17) et la partie (19, 21) de chacune desdites au moins deux plaques.

7. Procédé (1) selon l'une des revendications précédentes, **caractérisé en ce que** chaque au moins un pont de matière (12, 14) comporte une section rétrécie à l'extrémité reliée à ladite partie de la pièce permettant de créer une zone de faiblesse apte à faciliter l'étape d).

8. Procédé (1) selon l'une des revendications précédentes, **caractérisé en ce que** plusieurs parties (19, 21) sont formées sur chaque plaque (11, 13) afin de former plusieurs pièces (31, 41, 51) lors de l'étape c).

9. Procédé (1) selon l'une des revendications précédentes, **caractérisé en ce que** la cheville (29) est prolongée à chacune de ses extrémités par un tigeron comportant un pivot afin de former un axe de pivotement.

10. Procédé (1) selon l'une des revendications précédentes, **caractérisé en ce que** la cheville (29) comporte coaxialement un anneau (30) destiné à servir de butée pour limiter la pénétration de ladite cheville dans lesdits trous.

11. Procédé (1) selon la revendication 10, **caractérisé en ce que** ledit anneau coaxial (30) comporte une denture afin de former un pignon.

12. Procédé (1) selon l'une des revendications précédentes, **caractérisé en ce qu'**au moins une desdites plaques est formée lors de l'étape a) à l'aide d'un processus d'électrodéposition.

13. Procédé (1) selon l'une des revendications précédentes, **caractérisé en ce qu'**au moins une desdites plaques est formée lors de l'étape a) à l'aide d'un processus de micro-usinage.

14. Procédé (1) selon l'une des revendications précédentes, **caractérisé en ce qu'**au moins une sous-partie est montée sur au moins une desdites parties de manière latérale par rapport à ladite plaque avant, pendant ou après l'étape b).

## Patentansprüche

1. Verfahren (1) zum Herstellen eines mikromechanischen Teils (31, 41, 51), das die folgenden Schritte umfasst:
a) Bilden (3) von wenigstens zwei Platten (11, 13), wovon jede einen Rahmen (15, 17) aufweist, der durch wenigstens eine Materialbrücke (12, 14) mit einem Abschnitt (19, 21) des Teils verbunden ist;
b) Stapeln (5) der wenigstens zwei Platten gegen einen Träger (23), um wenigstens zwei der Abschnitte zu stapeln;
**dadurch gekennzeichnet, dass** es außerdem die folgenden Schritte umfasst:
c) Befestigen (7) eines gleichen Zapfens (29) in einem Loch (16, 18) jedes der wenigstens zwei gestapelten Abschnitte, um das Teil (31, 41, 51) zu bilden, wobei ein einziger Zapfen von wenigstens einer der gestapelten Platten vorsteht, um als Greifmittel dienen zu können;
d) Freigeben (9) des gebildeten Teils (31, 41, 51) von den wenigstens zwei Platten (11, 13).

2. Verfahren (1) nach Anspruch 1, **dadurch gekennzeichnet, dass** der Schritt b) für jede Platte (11, 13) die folgenden Schritte umfasst:
e) Führen (B) der Platte mithilfe von Ausrichtmitteln (25), um die Platte in Bezug auf den Träger (23) zuverlässig zu orientieren;
f) Schieben (A) der Platte gegen wenigstens eine Welle (22), die mit dem Träger (23) fest verbunden ist, bis sie an einer Schulter (24) der Welle anschlägt, um die Platte in Bezug auf den Träger (23) zuverlässig anzuordnen.

3. Verfahren (1) nach Anspruch 2, **dadurch gekennzeichnet, dass** jedes der Ausrichtmittel wenigstens einen abgefasten Ring aufweist, der in der Verlängerung der wenigstens einen Welle des Trägers (23) montiert ist und dazu bestimmt ist, mit einer Aussparung (20, 26), die in jeder der wenigstens zwei Platten im Schritt a) verwirklicht wird, zusammenzuwirken.

4. Verfahren (1) nach Anspruch 2 oder 3, **dadurch gekennzeichnet, dass** das Führen des Schrittes e) mit wenigstens zwei Ausrichtmitteln (25) erfolgt, um die Zuverlässigkeit zu verbessern.

5. Verfahren (1) nach Anspruch 3 oder 4, wenn abhängig von Anspruch 3, **dadurch gekennzeichnet, dass** jede Aussparung (20, 26) in dem Rahmen (15, 17) der wenigstens zwei Platten verwirklicht ist.

6. Verfahren (1) nach Anspruch 3 oder 4, wenn abhängig von Anspruch 3, **dadurch gekennzeichnet, dass** jede Aussparung einem Raum zwischen dem Rahmen (15, 17) und dem Abschnitt (19, 21) jeder der wenigstens zwei Platten entspricht.

7. Verfahren (1) nach einem der vorhergehenden Ansprüche, **dadurch gekennzeichnet, dass** jede der wenigstens einen Materialbrücke (12, 14) an dem Ende, das mit dem Abschnitt des Teils verbunden ist, einen verengten Querschnitt aufweist, der ermöglicht, eine geschwächte Zone zu erzeugen, die den Schritt d) erleichtert.

8. Verfahren (1) nach einem der vorhergehenden Ansprüche, **dadurch gekennzeichnet, dass** auf jeder Platte (11, 13) mehrere Abschnitte (19, 21) ausgebildet sind, um im Schritt c) mehrere Teile (31, 41, 51) zu bilden.

9. Verfahren (1) nach einem der vorhergehenden Ansprüche, **dadurch gekennzeichnet, dass** der Zapfen (29) an jedem seiner Enden durch einen Stift verlängert ist, der einen Wellenzapfen aufweist, um eine Schwenkwelle zu bilden.

10. Verfahren (1) nach einem der vorhergehenden Ansprüche, **dadurch gekennzeichnet, dass** der Zapfen (29) koaxial einen Ring (30) aufweist, der dazu bestimmt ist, als Anschlag zu dienen, um das Eindringen des Zapfens in die Löcher zu begrenzen.

11. Verfahren (1) nach Anspruch 10, **dadurch gekennzeichnet, dass** der koaxiale Ring (30) eine Zahnung aufweist, um ein Ritzel zu bilden.

12. Verfahren (1) nach einem der vorhergehenden Ansprüche, **dadurch gekennzeichnet, dass** wenigstens eine der Platten im Schritt a) mithilfe eines galvanischen Plattierungsprozesses gebildet wird.

13. Verfahren (1) nach einem der vorhergehenden Ansprüche, **dadurch gekennzeichnet, dass** wenigstens eine der Platten im Schritt a) mithilfe eines Mikrobearbeitungsprozesses gebildet wird.

14. Verfahren (1) nach einem der vorhergehenden Ansprüche, **dadurch gekennzeichnet, dass** während des Schrittes b), zuvor oder danach wenigstens ein Unterabschnitt an wenigstens einem der Abschnitte seitlich in Bezug auf die vordere Platte montiert wird.

## Claims

1. Method (1) of fabricating a micro-mechanical component (31, 41, 51) that includes the following steps:
a) forming (3) at least two plates (11, 13) that each includes a frame (15, 17) connected by at least one bridge of material (12, 14) to a part (19, 21) of said component;
b) stacking (5) said at least two plates against a support (23) so as to stack at least two of said parts;
**characterized in that** it further includes the following steps:
c) securing (7) a unique pin (29) in a hole (16, 18) of each at least two stacked parts so as to form the component (31, 41, 51) with a single pin protruding from at least one of the stacked plates so as to use it as gripping means;
d) releasing (9) the formed component (31, 41, 51) from said at least two plates (11, 13).

2. Method (1) according to claim 1, **characterized in that** step b) includes the following steps for each plate (11, 13):
e) guiding (B) said plate using alignment means (25) so as to orient said plate accurately relative to the support (23);
f) sliding (A) said plate against at least one arbour (22) secured to the support (23) until said plate abuts against a shoulder (24) of said arbour so as to place said plate accurately relative to the support (23).

3. Method (1) according to claim 2, **characterized in that** each of said alignment means includes at least one bevelled ring, which is mounted in the extension of said at least one arbour of the support (23), and which cooperates with a recess (20, 26) made in each of said at least two plates in step a).

4. Method (1) according to claim 2 or 3, **characterized in that** the guiding operation in step e) is performed using at least two alignment means (25) so as to improve the accuracy of said guiding.

5. Method (1) according to claim 3 or 4 depending from claim 3, **characterized in that** each recess (20, 26) is made in the frame (15, 17) of said at least two plates.

6. Method (1) according to claim 3 or 4 depending from claim 3, **characterized in that** each recess is a space between the frame (15, 17) and the part (19, 21) of each of said at least two plates.

7. Method (1) according to any of the preceding claims, **characterized in that** each at least one bridge of material (12, 14) includes a narrow section at the end that is connected to said part of the component, so as to create an area of weakness that can facilitate step d).

8. Method (1) according to any of the preceding claims, **characterized in that** several parts (19, 21) are formed on each plate (11, 13) so as to form several components (31, 41, 51) in step c).

9. Method (1) according to any of the preceding claims, **characterized in that** the pin (29) is extended at each end thereof by a pivot-shank that includes a pivot to form a pivoting arbour.

10. Method (1) according to any of the preceding claims, **characterized in that** the pin (29) has a coaxial ring (30) used as a stop member for limiting the penetration of said pin in said holes.

11. Method (1) according to claim 10, **characterized in that** said coaxial ring (30) has a toothing so as to form a pinion.

12. Method (1) according to any of the preceding claims, **characterized in that** at least one of said plates is formed in step a) using an electroplating process.

13. Method (1) according to any of the preceding claims, **characterized in that** at least one of said plates is formed in step a) using a micro-machining process.

14. Method (1) according to any of the preceding claims, **characterized in that** at least one sub-part is mounted laterally on at least one of said parts relative to said plate before, during or after step b).
